(19) Europäisches Patentamt
European Patent Office
Office européen des brevets

(11) Veröffentlichungsnummer : **0 106 156**
**B1**

# (12) EUROPÄISCHE PATENTSCHRIFT

(45) Veröffentlichungstag der Patentschrift : **21.12.88**

(51) Int. Cl.⁴ : **G 03 F 7/10**, C 08 G 65/34, C 08 G 8/04

(21) Anmeldenummer : **83109022.0**

(22) Anmeldetag : **13.09.83**

## (54) Lichtempfindliches Gemisch.

(30) Priorität : **22.09.82 US 421685**

(43) Veröffentlichungstag der Anmeldung : **25.04.84 Patentblatt 84/17**

(45) Bekanntmachung des Hinweises auf die Patenterteilung : **21.12.88 Patentblatt 88/51**

(84) Benannte Vertragsstaaten : **DE FR GB IT**

(56) Entgegenhaltungen : **Keine Entgegenhaltungen**

(73) Patentinhaber : **HOECHST CELANESE CORPORATION
Route 202-206 North
Somerville, N.J. 08876 (US)**

(72) Erfinder : **Walls, John E.
46 Center Street
Annandale New Jersey 08801 (US)**
Erfinder : **Duyal, Tulay
15 Alexandria Drive
Manalapan New Jersey 07726 (US)**

(74) Vertreter : **Euler, Kurt Emil, Dr.
HOECHST AG - Werk KALLE Patentabteilung Postfach 3540 Rheingaustrasse 190
D-6200 Wiesbaden (DE)**

**EP 0 106 156 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft ein lichtempfindliches Gemisch auf Basis von ungesättigten Polymeren, das bei Belichtung in einem Entwickler löslich wird. Das lichtempfindliche Gemisch läßt sich auch ohne Zusatz von Bindemitteln leicht zu Folien oder haftfähigen Beschichtungen verarbeiten, die zur Herstellung von Druckplatten und anderen lichtempfindlichen Materialien sowie von Leiterplatten für die Elektronikindustrie verwendet werden können.

Es ist bekannt, bestimmte Polyaldehyde durch photoinduzierte Radikalbildung oder durch photolytisch erzeugte Säure bildmäßig abzubauen bzw. zu depolymerisieren, so daß die belichteten Bereiche besser löslich werden (US-A 3 917 483 ; 3 923 514 und 3 964 907).

Aus der DE-C 2 064 380 ist ferner ein positiv arbeitendes lichtempfindliches Gemisch aus einem Polymerisat mit sauren Substituenten und einer mehrkernigen N-heterocyclischen Verbindung als Photoinitiator bekannt.

Die bekannten Materialien haben teils eine zu geringe Lichtempfindlichkeit oder Lagerfähigkeit, teils neigen die verwendeten Polymerisate zur Bildung spröder Schichten.

Aufgabe der Erfindung war es, ein neues positiv arbeitendes lichtempfindliches Gemisch vorzuschlagen, das sich durch hohe Lichtempfindlichkeit, gute Dunkellagerfähigkeit, gute Flexibilität und Filmbildungsfähigkeit auszeichnet und das sich leicht mit umweltfreundlichen wäßrig-alkalischen Lösungen entwickeln läßt.

Gegenstand der Erfindung ist ein lichtempfindliches Gemisch, dessen Löslichkeit bei Belichtung zunimmt, aus einem Polykondensat und einem bei Belichtung freie Radikale bildenden Photoinitiator.

Das erfindungsgemäße Gemisch ist dadurch gekennzeichnet, daß das Polykondensat eine Verbindung ist, die durch Polykondensation einer Verbindung der Formel

$$R—M—R,$$

worin

R $CH_2OH$, $C(CH_3)_2OH$, $CH_2OC_qH_{2q+1}$ oder $CH_2OCOC_rH_{2r+1}$,

M der Rest eines aromatischen Kohlenwasserstoffs, eines Diarylethers, eines Diarylsulfids, eines Diarylsulfons, eines Diarylamins, eines Diarylketons oder -diketons,

q eine Zahl von 1 bis 4 und

r eine Zahl von 1 bis 3 ist,

in stark saurem Medium und Umsetzen der Endgruppen des Polykondensats mit dem Halogenid einer ungesättigten Carbonsäure oder einem Alkenylhalogenid herstellbar ist.

Das Polykondensat kann ein Molgewicht haben, das ausreicht, um zähe, haftfähige und gegebenenfalls von Bindemitteln weitgehend freie Folien und Beschichtungen zu bilden, in denen es jedoch bei der Bestrahlung mit aktinischer elektromagnetischer Strahlung leicht zu einem selektiven, radikalisch induzierten Abbau kommt. Die mit relativ geringen Mengen an Sensibilisator erzielbare hohe Lichtempfindlichkeit ergibt ein leistungsfähiges und dabei doch wirtschaftliches System, in dem sich die aufgezeichneten Informationen dadurch einfach entwickeln lassen, daß die belichtete Oberfläche der Folie oder Beschichtung mit einer alkalischen Lösung in Kontakt gebracht wird.

Das erfindungsgemäß eingesetzte Polymere kann hergestellt werden durch :

a) Kondensation einer Verbindung R—M—R mit sich selbst,

b) Kondensation von mindestens zwei verschiedenen Verbindungen R—M—R miteinander oder

c) Kondensation einer Verbindung R—M—R mit Formaldehyd.

Neben den Verbindungen R—M—R können auch kleinere Mengen an monofunktionellen Verbindungen R—M oder mehrfunktionellen Verbindungen, z. B. $R—M(—R)_2$, zugesetzt werden. Monomere der Formeln R—M—R oder $R—M(—R)_2$, die für die Herstellung von Polymeren für die lichtempfindlichen Gemische dieser Erfindung geeignet sind, sind z. B. die folgenden :

1,5-Bis-acetoxymethyl-naphthalin,
1,4-Bis-hydroxymethyl-naphthalin,
2,6-Bis-hydroxymethyl-naphthalin,
9,10-Bis-methoxymethyl-anthracen,
4,4'-Bis-methoxymethyl-diphenylmethan,
4,4'-Bis-acetoxymethyl-diphenylsulfon,
4,4'-Bis-methoxymethyl-benzophenon,
4-Hydroxy-3,5'-bis-hydroxymethyl-diphenylether,
2,2'-Dihydroxy-3,3'-bis-hydroxymethyl-diphenylmethan,
1,3-Bis-(3-hydroxymethyl-phenoxy)-propan,
1,5-Bis-(4-hydroxymethyl-phenoxy)-pentan,
Bis-[2-(4-hydroxymethyl-phenoxy)-ethyl] ether,
4,4'-Bis-hydroxymethyl-diphenylether,
4,4'-Bis-acetoxymethyl-diphenylether,

4,4'-Bis-methoxymethyl-diphenylether,
4,4'-Bis-ethoxymethyl-diphenylether,
2,4,4'-Tris-methoxymethyl-diphenylether,
4,4'-Bis-methoxymethyl-diphenylsulfid,
3,3'-Dihydroxy-2,4'-bis-methoxymethyl-diphenylsulfid,
1,3-Bis-(4-methoxymethyl-phenoxy)-benzol,
1,3-Bis-(4-methoxymethyl-phenoxy)-propan,
4,4'-Bis-methoxymethyl-benzil.

Obwohl alle diese Monomeren für den genannten Zweck geeignet sind, werden die nachstehend aufgeführten bevorzugt :

4,4'-Bis-hydroxymethyl-diphenylether,
4,4'-Bis-methoxymethyl-diphenylether,
4,4'-Bis-methoxymethyl-diphenylsulfid,
4,4'-Bis-methoxymethyl-benzophenon,
4,4'-Bis-acetoxymethyl-diphenylmethan.

Gemäß einer Ausführungsform der Erfindung können zusätzliche Monomere entsprechend der Formel R—M—R, mit R = $—CH_2J$, $—CH_2Cl$ oder $—CH_2Br$, für den Aufbau des erfindungsgemäßen Polymeren verwendet werden. Diese halogenierten Monomeren können jedoch nicht allein zur Herstellung des Polymeren genommen werden, sondern nur im Gemisch mit einer größeren Menge an R—M—R—Monomeren, in denen R eine gegebenenfalls veretherte oder veresterte Hydroxygruppe enthält.

Die genannten Monomeren werden im sauren Medium kondensiert. Zu diesem Zweck wird eine Säure entsprechend der relativen Reaktionsfähigkeit der Monomeren gewählt. Normalerweise ist konzentrierte Schwefelsäure die am stärksten wirkende Säure für diese Polymerisation und bleibt daher dem am schwächsten reagierenden Monomeren vorbehalten. Für ein stark reagierendes Monomeres wird dagegen ein milderes Medium vorgezogen. In den meisten Fällen wird Phosphorsäure für die Kondensation bevorzugt. Die Temperatur bei der Kondensationsreaktion kann zwischen etwa — 10 und 70 °C liegen, vorzugsweise zwischen 5 und 50 °C. Bei diesen Temperaturen können die Reaktionszeiten, je nach der relativen Reaktionsfähigkeit des Monomeren, dem gewünschten Molgewicht des Produktes und der Kontrollierbarkeit der exothermen Reaktion, normalerweise zwischen etwa 15 Minuten und 30 Stunden variieren. Die bei der Polymerisationsreaktion freiwerdende Wärme wird genau überwacht und gesteuert, um zu verhindern, daß die Polymerisation des Monomeren außer Kontrolle gerät, wodurch es zu einer Bildung von hochmolekularen Stoffen mit begrenzter Löslichkeit kommen könnte.

Nach der Herstellung wird das Polykondensat bzw. Polymere gewaschen, und dabei werden die noch verbliebenen Monomeren und die anderen bei der Polymerisationsreaktion entstandenen Verunreinigungen entfernt. Dann wird das Polymere auf die herkömmliche Weise isoliert und getrocknet.

Das getrocknete Polymere wird anschließend bevorzugt mit einem ungesättigten Carbonsäurechlorid weiter umgesetzt, wodurch ethylenisch ungesättigte funktionelle Gruppen an die Polymerkette angelagert werden und man so die neuen abbaubaren Verbindungen erhält.

Das getrocknete Polymere wird in einem inerten Lösemittel, wie Tetrahydrofuran, Dimethylformamid oder Dioxan, zusammen mit einer säurebindenden Verbindung, z. B. einem primären, sekundären oder tertiären aliphatischen oder heterocyclischen Amin, wie Pyridin, Mono-, Di- oder Triethyl- oder -ethanolamin, gelöst. Dann wird das ungesättigte Carbonsäurehalogenid zugefügt und die Reaktion bei 10 bis 80 °C über etwa 15 bis 48 Stunden durchgeführt.

Das ungesättigte Alkenyl- oder Carbonsäurehalogenid kann durch die folgende Strukturformel dargestellt werden :

$$R_5 - \overset{H}{\overset{|}{C}} = \overset{R_4}{\overset{|}{C}} - \overset{V}{\overset{|}{C}} = Z.$$

In dieser Formel ist
$R_5$ = H, Aryl, Alkyl, Aralkenyl oder Phenoxyphenyl,
$R_4$ = H oder $CH_3$,
Z = $H_2$ oder O und
V = Halogen.

Verbindungen nach dieser Formel, die für die oben beschriebene Synthese geeignet sind, sind z. B. Acryloylhalogenide, deren verschiedene Homologe, Cinnamoylhalogenide, Allylhalogenide und Phenoxycinnamoylhalogenide.

Man bringt diese Verbindungen im entsprechenden Verhältnis in einem geeigneten Reaktionsmedium, wie oben beschrieben, mit dem Polymeren zusammen und läßt die Reaktionsteilnehmer miteinander in Wechselwirkung treten. Das Reaktionsmedium, in dem solche Verbindungen vereinigt werden, ist fähig, dem Polymeren die darin enthaltene restliche Säure zu entziehen. Man erhitzt die Reaktionsteilnehmer auf die geeignete Temperatur und läßt die Mischung ausreagieren. Danach gießt man die Lösung mit dem Reaktionsprodukt zum Ausfällen und Abtrennen des Produkts in Wasser. Der Niederschlag wird abfiltriert und mehrmals gewaschen, um noch verbleibendes Lösemittel zu entfernen. Das so erhaltene Polymere wird getrocknet, bis es im wesentlichen frei von Flüssigkeitsresten ist. Das auf diese Weise hergestellte Polymere kann angenähert durch die folgende Strukturformel dargestellt werden :

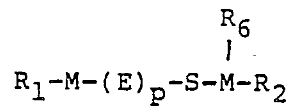

worin E mindestens eine der folgenden Gruppen ist :

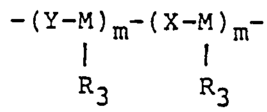

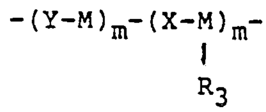 oder

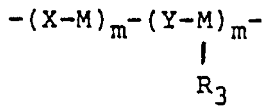

worin $R_1$ und $R_2$ =

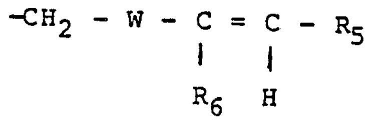

W = OCO oder $CH_2$,

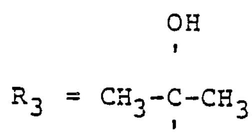

$—CH_2OH$, $—CH_2O(C_qH_{2q+1})$, $—CH_2—O—CO—C_rH_{2r+1}$, $—CH_2J$, $—CH_2Cl$, $—CH_2Br$ oder $R_1$,

S = X oder Y,

$R_6 = R_3$, wenn S = X ist, oder H, wenn S = Y ist,

m = eine Zahl von 1 bis 3,

p = eine Zahl von 1 bis 8,

$Y = —CH_2OCH_2—$,

$X = —CH_2—$ ist und

$R_4$, $R_5$, q und M die oben angegebene Bedeutung haben.

In der bevorzugten Ausführung liegt das Verhältnis X : Y im Bereich von 1 : 1 bis 3 : 1 und beträgt vorzugsweise 2 : 1.

Als Sensibilisator, der bei der Formulierung der erfindungsgemäßen Gemische mit dem obengenannten Polymeren kombiniert werden kann, ist jeder Stoff verwendbar, der mit dem Polymeren im wesentlichen verträglich ist und bei der Aktivierung mit bilderzeugenden Energien den Abbau dieses Polymeren bewirken kann. Es wird angenommen, daß der Sensibilisator beim Übergang vom Grundzustand in den angeregten Zustand die Bildung von Radikalen im Polymeren induziert, wodurch das Polymere in Bestandteile mit geringerem Molgewicht aufgespalten wird. Diese Sensibilisatoren haben im allgemeinen einen Lichtempfindlichkeitsbereich, der im wesentlichen außerhalb des Bereichs der primären Lichtempfindlichkeit des Polymeren liegt. Sensibilisatoren, die in den erfindungsgemäßen lichtempfindlichen Gemischen eingesetzt werden können, sind beispielsweise die Benzophenone,

Benzil, Benzoin, Acetophenon, Thioxanthon, Anthrachinon und die entsprechenden substituierten Verbindungen. Substituenten können z. B. Methyl-, Ethyl-, n-Propyl-, Isopropyl-, n-Butyl-, t-Butyl-, Hexyl-, Methoxy-, Ethoxy-, n-Propoxy-, Isopropoxy-, Butoxy-, Acetoxy-, Dimethylamino- und Diethylaminogruppen sein.

Die lichtempfindlichen Gemische dieser Erfindung können gegebenenfalls noch verschiedene andere übliche polymere oder auch nicht polymere Zusätze enthalten, durch die das fertige Gemisch modifiziert wird. Geeignete Polymere, die in Verbindung mit den erfindungsgemäßen lichtempfindlichen Gemischen verwendet werden können, sind z. B. polymere Bindemittel, Substanzen zur Erhöhung der Lichtempfindlichkeit, Photostabilisatoren, Farbmittel, Füllstoffe und andere Hilfsstoffe, die eine oder mehrere der physikalischen Eigenschaften des fertigen Gemisches verbessern oder verändern sollen. Selbstverständlich dürfen sich solche Zusätze von modifizierenden Substanzen zu dem Gemisch auf die Wirksamkeit der Sensibilisatorverbindung oder deren Wechselwirkung mit dem Polymeren im wesentlichen nicht störend auswirken.

Geeignete Bindemittel sind zum Beispiel Polyvinylacetale, Polymere und Copolymere von Methylmethacrylat, Ethylmethacrylat und Acrylsäure, Novolakharze, Polyvinylacetate und Polyvinylchloride.

Beispiele für Farbmittel sind Phthalocyaninpigmente, z. B. $^{R}$Hostaperm (Hoechst AG) und $^{R}$Monastral (DuPont), und Farbstoffe, z. B. Säurefarbstoffe, öllösliche Farbstoffe, Viktoriablau, Samaronblau, Alizarinrot und Sudanrot.

Brauchbare Photostabilisatoren sind die handelsüblichen Produkte $^{R}$Unival (GAF) und $^{R}$Tinuvin (Ciba-Geigy).

Eine Folie oder Beschichtung kann hergestellt werden, indem die oben beschriebenen Stoffe in einem üblichen Lösemittel gelöst werden und die entstandene Lösung dann auf einen geeigneten Träger durch Gießen oder andere Auftragsverfahren aufgebracht wird. Wie bereits erwähnt, können die Bestandteile des lichtempfindlichen Gemisches selbsttragende Folien und Beschichtungen bilden, die von Bindemitteln unabhängig sind. Die relative Menge jedes im Gemisch enthaltenen Stoffes sollte sorgfältig eingestellt werden, um die größtmögliche Strahlungsempfindlichkeit der Folie sicherzustellen und gleichzeitig zu gewährleisten, daß die resultierenden physikalischen Eigenschaften der Folie in den durch den Verwendungszweck des Produktes auferlegten Grenzen bleiben. In den Fällen, in denen aus dem lichtempfindlichen Gemisch beispielsweise eine selbsttragende Folie hergestellt werden soll, muß das Mengenverhältnis von Polymerem zu Sensibilisator so eingestellt werden, daß eine für diesen Zweck ausreichende mechanische Festigkeit und ein ausreichender innerer Zusammenhalt gesichert sind. Soll das lichtempfindliche Gemisch dagegen als Beschichtung auf einen Träger aufgebracht werden, können andere Anforderungen gelten. Geeignete Lösemittel zur Herstellung von Folien und Beschichtungen aus dem Gemisch sind z. B. 2-Methoxyethanol, 2-Methoxyethylacetat, Ethylacetat, Butylacetat, N,N-Dimethylformamid (DMF), Tetrahydrofuran (THF), Xylol und Methylethylketon. In einer typischen Formulierung der erfindungsgemäßen lichtempfindlichen Gemische liegt das Verhältnis von Sensibilisator zu Polymerem gewöhnlich zwischen etwa 1 : 10 und 5 : 6, vorzugsweise zwischen etwa 1 : 2 und 1 : 3.

Als Träger für die erfindungsgemäßen lichtempfindlichen Beschichtungen kann praktisch jedes auf dem Drucksektor und bei der Herstellung von Leiterplatten für die Elektronikindustrie gebräuchliche Material eingesetzt werden. Als einzige Bedingung gilt, daß der Träger relativ inert ist, d. h. nicht mit den aus den erfindungsgemäßen lichtempfindlichen Gemischen hergestellten Beschichtungen reagiert. Solche Trägermaterialien sind beispielsweise Aluminiumlegierungen, Silicium, Polyester und andere Kunststoffe, an denen gegebenenfalls die praxisüblichen Oberflächenbehandlungen durchgeführt worden sind.

In bevorzugter Ausführung hat der Schichtträger die Form einer Metallplatte, vorzugsweise aus Aluminium oder einer Aluminiumlegierung, insbesondere aus den für die Anfertigung von Flachdruckplatten geeigneten Legierungen, wie z. B. Alcoa 3003 und Alcoa 1100, die gegebenenfalls den üblichen Vorbehandlungen, wie Aufrauhung und/oder Ätzung und/oder Anodisierung, unterzogen worden sind und eventuell auch mit einer Lösung behandelt worden sind, die sich zur Herstellung einer Zwischenschicht auf Flachdruckplatten eignet.

Geeignete Lösungen zur Herstellung einer Zwischenschicht sind wäßrige Lösungen von Polyvinylphosphonsäure, Alkalisilikat, Kieselsäure, komplexen Fluoriden von Metallen der vierten Nebengruppe, Polyacrylsäure, Alkalifluorozirkonaten, wie Kaliumhexafluorozirkonat, oder Hexafluorozirkonsäure in Konzentrationen von 0,5 bis 20 Vol.-%, die durch Sprühen, Auftragen mit dem Pinsel, Tauchen oder andere gleichwertige Methoden aufgebracht werden.

Nachdem die Folien und Beschichtungen aus den vorgenannten Bestandteilen hergestellt und auf den geeigneten Träger aufgetragen worden sind, können sie mit Hilfe von aktinischer elektromagnetischer Strahlung bildmäßig belichtet werden. Als Strahlungsquellen können zum Beispiel Quecksilberdampflampen und Laser eingesetzt werden, und es kann im Projektionsverfahren belichtet werden. Die aus dem lichtempfindlichen Gemisch hergestellte Folie oder Beschichtung wird gewöhnlich unter einer Vorlage belichtet.

Nach dem Belichten kann die Bildinformation dadurch entwickelt werden, daß man die Oberfläche der Folie oder Beschichtung in bekannter Weise mit einer wäßrig-alkalischen Lösung in Kontakt bringt. Das erhaltene Bild kann dann als Grundlage zum Drucken oder als Photoresist verwendet werden.

Als Entwickler sind u. a. wäßrig-alkalische Lösungen von Natrium-, Kalium-, Lithium- oder Ammoniumhydroxid, -carbonat, -phosphat und -silikat geeignet, z. B. von NaOH, KOH, LiOH, $Na_2CO_3$, $Na_3PO_4$, $NaHCO_3$, $Na_2HPO_4$ und $Na_2SiO_3$ sowie von Mischungen dieser Verbindungen. Die Hydroxide haben die beste Wirkung bei Konzentrationen zwischen 0,25 und 5,0 %, die Phosphate und Carbonate zwischen 1,0 und 12 % und die Silikate zwischen 0,1 und 8 %. Die Kalium-, Lithium- und Ammoniumsalze können auch zusammen mit oder anstelle von Natriumsalzen verwendet werden.

Die folgenden Beispiele sollen einige bevorzugte Ausführungen der Erfindung näher erläutern. Sofern nicht anders angegeben, beziehen sich in den Beispielen die Mengenangaben auf Gewichtsteile bzw. Gewichtsprozente.

## Beispiel 1

25,8 g 4,4'-Bis-methoxymethyl-diphenylether werden langsam in 113,5 g Phosphorsäure (85 %) gegeben, in der 6,0 g Paraformaldehyd gelöst sind. Beim Eintropfen des Diphenylethers in die Säure wird stark gerührt und danach 4 Stunden stehengelassen. Während der Reaktionszeit wird die Temperatur gleichbleibend bei 40 °C gehalten. Das Reaktionsprodukt wird durch Ausfällen in 4 l Wasser isoliert und gut gewaschen, um alle Säurereste zu entfernen. Anschließend wird es bei 40 °C im Vakuumtrockner getrocknet.

16,0 g dieses Reaktionsproduktes werden in 50,0 g Pyridin gelöst, die Lösung wird auf 50 °C erwärmt und 2 Stunden gerührt. Bei einer gleichbleibenden Temperatur von 50 °C werden 4,0 g Cinnamoylchlorid zugegeben, und es wird weitere 4 Stunden gerührt. Anschließend werden 10 g Aceton und dann 1 Liter entsalztes Wasser hinzugefügt, um das Endprodukt auszufällen. Mit 0,1 n HCl werden dann alle Reste von Pyridin aus dem Produkt ausgewaschen. Der Niederschlag wird im Vakuumtrockner getrocknet, bis er vollständig frei von Wasser ist.

Das erhaltene Harzprodukt ist eine schmutzig-weiße Substanz, die zu einem feinen Pulver vermahlen wird. 3,0 g dieses Harzes werden in 96,0 g Tetrahydrofuran gelöst und mit 1,0 g 2-Ethylanthrachinon versetzt. Die Lösung wird auf eine Aluminiumoberfläche aufgeschleudert, die zuvor entfettet, mit einer Quarzaufschlämmung naß aufgerauht und zur Hydrophilierung der Oberfläche mit einer 0,2 %igen wäßrigen Lösung von Kaliumhexafluorozirkonat behandelt wurde. Die beschichtete Platte wird unter einer positiven und negativen Testvorlage mit unterschiedlichen Graden der Auflösung sowie Strich- und Rasterteilen bildmäßig belichtet. Die Testvorlage wird dabei so auf die Platte gelegt, daß sie mit der Schichtseite auf der Schicht der Platte liegt. Die Platte wird im Vakuum mit UV-Strahlung von 250 $mJ/cm^2$ belichtet. Nach dem Belichten wird die Platte entweder mit einem rein wäßrig-alkalischen Entwickler (1,0 n NaOH + 2,0 % $Na_2SiO_3$) oder einem wäßrigen Entwickler, der 20 % n-Propanol, 4,6 % Dextrin, 5,3 % Magnesiumcitrat, 0,8 % Trinatriumphosphat und 0,6 % Polyoxyethylenmonosorbitanoleat enthält, entwickelt. Nach dem Belichten und Entwickeln ist kein Bild sichtbar ; um das Bild sichtbar zu machen, wird die Platte eingefärbt. Es entsteht ein positives Bild. Die Auflösung ist mit bekannten Systemen vergleichbar.

Zur Beurteilung des Druckverhaltens wird eine Platte für den Einsatz auf einer Druckpresse vorbereitet. Dort, wo das Bild die volle Druckfarbenmenge erhält, stellt man eine rasche Farbannahme fest, und der Druck hat sehr dichte Volltonflächen. In den Strich- und Rasterteilen stimmt die Detailwiedergabe genau mit der Vorlage überein.

## Beispiel 2

Die Verbindung von Beispiel 1 wird im Hinblick auf ihre Verwendbarkeit in Photoresist beurteilt. Zu diesem Zweck wird gleichfalls eine Aluminiumplatte beschichtet. Wenn man eine Zinn-II-chloridlösung mit Aluminium in Kontakt bringt, führt die eintretende Reaktion bekanntlich zur Bildung von schwarzen Flecken auf dem Aluminium. Dieses Verfahren ist zur Beurteilung eines Photoresists üblich. Es besteht ein direktes Verhältnis zwischen der Zeit, die das Zinn-II-chlorid zum Durchdringen der Beschichtung braucht, und der Wirksamkeit der Beschichtung als Photoresist. Auf eine Probeplatte, auf der einzelne Bereiche mit dem erfindungsgemäßen Produkt geschützt sind, wird eine Zinn-II-chloridlösung aufgebracht. In den ungeschützten Bereichen der Platte entstehen innerhalb von 14 Sekunden Flecken, während es in den durch die Beschichtung geschützten Bereichen 257 Sekunden bis zur Bildung solcher Flecken dauert.

## Beispiel 3

Es wird eine bildmäßig beschichtete Platte gemäß Beispiel 2 hergestellt. Ein Teil der Platte wird 5 Minuten in 1,0 n HCl getaucht und anschließend dem Zinn-II-chloridtest unterzogen. In diesem Fall dauert es 231 Sekunden, bis in dem vom Resist geschützten Bereich eine Reaktion eintritt.

## Beispiel 4

Es wird eine bildmäßig beschichtete Platte gemäß Beispiel 2 hergestellt. Ein Teil der Platte wird 5 Minuten in 0,1 n NaOH getaucht und anschließend dem Zinn-II-chloridtest unterzogen. In diesem Fall wird

die Platte durch die NaOH-Lösung geätzt und zeigt in dem ungeschützten Bereich eine sofortige Reaktion. Der Resistbereich ist durch die alkalische Lösung unterätzt worden und daher unregelmäßig, in der Mitte hält er jedoch dem Zinn-II-chlorid für die Dauer von 207 Sekunden stand.

Beispiel 5

28,6 g 4,4'-Bis-methoxymethyl-benzophenon werden in 115,0 g Phosphorsäure (85 %) gelöst und 2 Stunden bei 40 °C gerührt ; während dieser Zeit läuft die Kondensationsreaktion ab. Anschließend wird die Lösung in 2 l Wasser gegeben und das Produkt ausgefällt. Der Harzniederschlag wird durch gründliches Waschen von allen Säureresten befreit und dann getrocknet.

3,0 g des getrockneten Produktes werden in 96,0 g Dimethylformamid mit einem Gehalt von 1,0 g 2-Ethylanthrachinon gelöst und wie in Beispiel 1 beschrieben auf einen Aluminiumträger aufgeschleudert. Unter einer Testvorlage wird die Platte mit UV-Strahlung bei 250 mJ/cm$^2$ belichtet. Die belichtete Platte wird entwickelt und dann eingefärbt. Anfangs ist ein schwaches positives Bild zu erkennen, das sich jedoch leicht wieder wegwischen läßt. Daraus kann man schließen, daß sich ohne Umsetzen des Polymeren mit dem ethylenisch ungesättigten Säurechlorid keine mit der Platte aus Beispiel 1 vergleichbare Platte ergibt.

Beispiel 6

14,3 g 4,4'-Bis-methoxymethyl-benzophenon werden in 55 g Pyridin gelöst. Diese Lösung wird bei 50 °C 2 Stunden gerührt und dann unter ständigem Rühren mit 3,9 g Acryloylchlorid versetzt. Die Reaktionslösung wird 30 Stunden gerührt. Danach wird die Lösung in 2,0 l Wasser gegossen und das Produkt ausgefällt. Das Produkt wird abfiltriert und dann gewaschen und getrocknet.

3,0 g des Polymeren werden in 96,0 g Dimethylformamid mit 1,0 g 2-Ethylanthrachinon gelöst und wie in Beispiel 1 beschrieben auf einen Aluminiumträger aufgeschleudert. Die Platte wird unter einer Testvorlage mit UV-Strahlung bei 250 mJ/cm$^2$ belichtet. Die belichtete Platte wird entwickelt und dann eingefärbt. Anfangs zeigt sich ein schwaches Bild, das in diesem Fall negativ ist. Das Bild läßt sich durch leichtes Reiben ohne Schwierigkeit wieder entfernen. Aus diesem Beispiel läßt sich folgern, daß vor der Umsetzung mit der ungesättigten Verbindung unbedingt eine Vorkondensationsreaktion des Monomeren stattfinden muß. Ohne Vorkondensation gibt es keinen Zusammenhalt des Bildes, und das Bild ist negativ und nicht positiv.

Beispiel 7

14,3 g des Reaktionsprodukts aus Beispiel 5, bei dem 4,4'-Bis-methoxymethyl-benzophenon einer Vorkondensation unterzogen wurde, werden in 55 g Pyridin gelöst. Die Mischung wird bei 50 °C 2 Stunden gerührt und dann unter ständigem Rühren mit 3,9 g Acryloylchlorid versetzt. Die Reaktionslösung wird 30 Stunden gerührt. Danach wird die Lösung in 2,0 l Wasser gegeben, um das Produkt auszufällen. Alle Reste von Lösemittel werden gründlich aus dem Harz ausgewaschen, und es wird anschliessend getrocknet.

3,0 g des getrockneten Polymeren und 1,0 g 2-Ethylanthrachinon werden in 96,0 g Tetrahydrofuran gelöst und auf eine Aluminiumplatte aufgeschleudert. Die Platte wird unter einer Testvorlage mit UV-Strahlung bei 250 mJ/cm$^2$ belichtet. Die belichtete Platte wird entwickelt und eingefärbt. Es entsteht ein kräftiges positives Bild mit guter Auflösung und Haftung auf dem Träger.

Beispiel 8

3,0 g Paraformaldehyd werden in 115 g Phosphorsäure (85 %) gelöst. Die Temperatur der Säure wird auf 40 °C eingestellt, und 14,3 g 4,4'-Bis-methoxymethyl-benzophenon werden unter ständigem Rühren zugegeben. Man läßt die Lösung zwei Stunden stehen und gibt dann 2 l Wasser zu, um das Kondensat auszufällen. Der Niederschlag wird gewaschen und neutralisiert, um alle Spuren von Säure zu entfernen, und dann getrocknet.

3,0 g des getrockneten Harzes und 1,0 g Ethylanthrachinon werden in 96,0 g Tetrahydrofuran gelöst und auf eine Aluminiumplatte aufgeschleudert. Unter einer Testvorlage wird die Platte mit UV-Strahlung von 250 mJ/cm$^2$ belichtet. Die Platte wird entwickelt und eingefärbt. Es zeigt sich ein kräftiges positives Bild mit guter Auflösung und fester Haftung auf dem Träger.

Beispiele 9 bis 12

Die Produkte aus den Beispielen 5 bis 8 werden im Zinn-II-chloridtest auf ihre Eignung als Photoresist geprüft. Die Ergebnisse sind in der nachfolgenden Tabelle aufgeführt.

Beständigkeit gegen das Eindringen von $SnCl_2$ (in Sekunden)

| Beispiel | Produkt aus Bsp. | Verleichsplatte | | Behandlung mit 1,0 n HCl (5 Minuten) | | Behandlung mit 0,1 n NaOH (5 Minuten) | |
|---|---|---|---|---|---|---|---|
| | | Hintergrund | Bild | Hintergrund | Bild | Hintergrund | Bild |
| 9 | 5 | 14 | 14 | 9 | 10 | sofort | sofort |
| 10 | 6 | 14 | 15 | 8 | 10 | sofort | sofort |
| 11 | 7 | 14 | 228 | 9 | 521 | sofort | 213 |
| 12 | 8 | 14 | 213 | 9 | 254 | sofort | 249 |

**Patentansprüche**

1. Lichtempfindliches Gemisch, dessen Löslichkeit bei Belichtung zunimmt, aus einem Polykondensat und einem bei Belichtung freie Radikale bildenden Photoinitiator, dadurch gekennzeichnet, daß das Polykondensat eine Verbindung ist, die durch Polykondensation einer Verbindung der Formel

R—M—R,

worin

R $CH_2OH$, $C(CH_3)_2OH$, $CH_2OC_qH_{2q-1}$ oder $CH_2OCOC_rH_{2r-1}$,

M der Rest eines aromatischen Kohlenwasserstoffs, eines Diarylethers, eines Diarylsulfids, eines Diarylsulfons, eines Diarylamins, eines Diarylketons oder -diketons,

q eine Zahl von 1 bis 4 und

r eine Zahl von 1 bis 3 ist,

in stark saurem Medium und Umsetzen der Endgruppen des Polykondensats mit dem Halogenid einer ungesättigten Carbonsäure oder einem Alkenylhalogenid herstellbar ist.

2. Lichtempfindliches Gemisch nach Anspruch 1, dadurch gekennzeichnet, daß der Photoinitiator Benzophenon, Benzil, Benzoin oder ein Benzoinether, Acetophenon, Thioxanthon, Anthrachinon oder ein substituiertes Derivat einer dieser Verbindungen ist.

3. Lichtempfindliches Gemisch nach Anspruch 1, dadurch gekennzeichnet, daß die Polykondensation unter Zusatz von Formaldehyd durchgeführt wird.

4. Lichtempfindliches Gemisch nach Anspruch 1, dadurch gekennzeichnet, daß die Polykondensation unter Zusatz von kleineren Mengen einer Verbindung der Formel R—M(—R)$_2$ oder R—M durchgeführt wird.

5. Lichtempfindliches Gemisch nach Anspruch 1, dadurch gekennzeichnet, daß M der Rest eines Diphenylethers oder eines Benzophenons ist.

6. Lichtempfindliches Gemisch nach Anspruch 1, dadurch gekennzeichnet, daß die ungesättigte Carbonsäure Acryl-, Methacryl- oder Zimtsäure ist.

**Claims**

1. Light-sensitive mixture whose solubility increases on exposure to light, composed of a polycondensate and a photo-initiator which forms free radicals on exposure to light, characterized in that the polycondensate is a compound which can be prepared by polycondensation of a compound of the formula

R—M—R,

wherein

R is $CH_2OH$, $C(CH_3)_2OH$, $CH_2OC_qH_{2q-1}$ or $CH_2OCOC_rH_{2r-1}$,

M is the radical of an aromatic hydrocarbon, of a diaryl ether, of a diaryl sulphide, of a diaryl sulphone, of a diaryl amine, of a diaryl ketone or diaryl diketone,

q is a number from 1 to 4 and

r is a number from 1 to 3,

in strongly acidic medium and reaction of the terminal groups of the polycondensate with the halide of an unsaturated carboxylic acid or an alkenyl halide.

2. Light-sensitive mixture according to Claim 1, characterized in that the photoinitiator is benzophenone, benzil, benzoin or a benzoin ether, acetophenone, thioxanthone, anthraquinone or a substituted derivative of one of these compounds.

3. Light-sensitive mixture according to Claim 1, characterized in that the polycondensation is carried out with the addition of formaldehyde.

4. Light-sensitive mixture according to Claim 1, characterized in that the polycondensation is carried out with the addition of small quantities of a compound of the formula R—M(—R)$_2$ or R—M.

5. Light-sensitive mixture according to Claim 1, characterized in that M is the radical of a diphenyl ether or a benzophenone.

6. Light-sensitive mixture according to Claim 1, characterized in that the unsaturated carboxylic acid is acrylic, methacrylic or cinnamic acid.

**Revendications**

1. Composition photosensible dont la solubilité s'accroît à l'exposition, à base d'un produit de polycondensation et d'un photoinitiateur engendrant des radicaux libres lors de l'exposition, caractérisée

en ce que le produit de polycondensation est un composé qui peut être obtenu par polycondensation d'un composé de formule

$$R—M—R,$$

dans laquelle

R représente $CH_2OH$, $C(CH_3)_2OH$, $CH_2OC_qH_{2q-1}$ ou $CH_2OCOC_rH_{2r-1}$,

M représente le reste d'un hydrocarbure aromatique, d'un éther diarylique, d'un sulfure de diaryle, d'une diarylsulfone, d'une diarylamine, d'une diarylcétone ou d'une diaryldicétone,

q étant un nombre valant de 1 à 4 et

r étant un nombre valant de 1 à 3,

en milieu fortement acide, et réaction des groupes terminaux du produit de polycondensation avec l'halogénure d'un acide carboxylique insaturé ou avec un halogénure d'alcényle.

2. Composition photosensible selon la revendication 1, caractérisée en ce que le photoinitiateur est la benzophénone, le benzile, la benzoïne ou un éther de benzoïne, l'acétophénone, la thioxanthone, l'anthraquinone ou un dérivé substitué d'un de ces composés.

3. Composition photosensible selon la revendication 1, caractérisée en ce que l'on effectue la polycondensation avec addition de formaldéhyde.

4. Composition photosensible selon la revendication 1, caractérisée en ce que l'on effectue la polycondensation avec addition de quantités relativement faibles d'un composé de formule $R—M(—R)_2$ ou R—M.

5. Composition photosensible selon la revendication 1, caractérisée en ce que M est le reste d'un éther diphénylique ou d'une benzophénone.

6. Composition photosensible selon la revendication 1, caractérisée en ce que l'acide carboxylique insaturé est l'acide acrylique, méthacrylique ou cinnamique.